# EUROPEAN PATENT APPLICATION

(11) **EP 4 575 624 A1**
(43) Date of publication of application: **25.06.2025**
(21) Application number: 24214845.0
(22) Date of filing: 22.11.2024
(51) Int. Cl.: G02F 1/1335, G02F 1/133

(54) **DISPLAY DEVICE**

(30) Priority: 19.12.2023 US 202363612331 P; 26.09.2024 CN 202411353605
(71) Applicant: InnoLux Corporation, Jhunan Town Miao li 35053 (TW); Carux Technology Pte. Ltd., Singapore 339510 (SG)
(72) Inventor: SU, Pao-Chuan, 74147 Tainan (TW); HU, Che-Chang, 74147 Tainan (TW); SU, Ching-Tsung, 74147 Tainan (TW); KUO, Ai-Ling, 35053 Jhunan Town, Miaoli County (TW)
(74) Representative: Becker, Eberhard

(57) **Abstract**

A display device (1) includes a display panel (10), an optical sensing unit (11), and an optical component (13). The optical sensing unit (11) is embedded in the display panel (10) and is located in a peripheral region (R1) of the display device (1). The optical component (13) is adjacent to a light entrance side (S11) of the optical sensing unit (11). A transmittance of the optical component (13) to light (L1) with a wavelength greater than or equal to 380 nm and less than or equal to 780 nm is less than 10%, and a transmittance of the optical component (13) to light (L2) with a wavelength greater than or equal to 900 nm and less than or equal to 1100 nm is higher than 70%.

## Description

### BACKGROUND

### Technical Field

The disclosure relates to an electronic device, and in particular, relates to a display device.

### Description of Related Art

In an electronic device, an exposed sensor can easily give users an unpleasant feeling of being monitored. If a light shielding layer is used to hide the sensor, however, the image quality will be affected because the light shielding layer absorbs visible light.

### SUMMARY

The disclosure provides a display device capable of lowering visibility of a sensor.

In an embodiment of the disclosure, a display device includes a display panel, an optical sensing unit, and an optical component. The optical sensing unit is embedded in the display panel and is located in a peripheral region of the display device. The optical component is adjacent to a light entrance side of the optical sensing unit. A transmittance of the optical component to light with a wavelength greater than or equal to 380 nm and less than or equal to 780 nm is less than 10%, and a transmittance of the optical component to light with a wavelength greater than or equal to 900 nm and less than or equal to 1100 nm is higher than 70%.

To make the aforementioned more comprehensible, several embodiments accompanied with drawings are described in detail as follows.

### BRIEF DESCRIPTION OF THE DRAWINGS

The accompanying drawings are included to provide a further understanding of the disclosure, and are incorporated in and constitute a part of this specification. The drawings illustrate exemplary embodiments of the disclosure and, together with the description, serve to explain the principles of the disclosure.
FIG. 1 is a schematic top view of a display device according to some embodiments of the disclosure.
FIG. 2 is a schematic cross-sectional view corresponding to a sectional line I-I' in FIG. 1.
FIG. 3 is a graph of a wavelength-transmittance relationship of an optical component in FIG. 2.
FIG. 4 is a partially enlarged schematic view of the optical component and an optical sensing unit in FIG. 2.
FIG. 5 is a partial schematic view of an exterior of a transportation device.
FIG. 6 and FIG. 9 are partial cross-sectional schematic views of various display devices according to some embodiments of the disclosure.
FIG. 10 is a partial schematic view of an interior of a transportation device.

### DESCRIPTION OF THE EMBODIMENTS

Descriptions of the disclosure are given with reference to the exemplary embodiments illustrated by the accompanying drawings. Wherever possible, the same reference numerals are used in the drawings and the description to refer to the same or like parts.

Certain terminologies will be used to refer to specific elements throughout the specification and the appended claims of the disclosure. A person having ordinary skill in the art should understand that manufacturers of electronic devices may refer to same elements under different names. The disclosure does not intend to distinguish elements with the same functions but different names. In the following specification and claims, the terminologies "containing", "comprising", etc. are open-ended terminologies, so they should be interpreted to mean "including but not limited to ...".

In the following embodiments, wording used to indicate directions, such as "up", "down", "front", "back", "left", and "right" merely refers to directions in the accompanying figures. Accordingly, the directional terminologies provided herein serve to describe rather than limiting the disclosure. In the accompanying drawings, each figure illustrates methods applied in particular embodiments and general features of structures and/or materials in the embodiments. However, these figures should not be construed or defined as the scope covered by the particular embodiments. For instance, relative dimensions, thicknesses, and positions of various layers, regions, and/or structures may be reduced or enlarged for clarity.

In the disclosure, if one structure (or layer, element, substrate) is described as being located on/above another structure (or layer, element, substrate), it can mean that the two structures are adjacent and are directly connected, or the two structures are adjacent to each other instead of being directly connected. Indirect connection means that at least one intermediary structure (or intermediary layer, intermediary element, intermediary substrate, intermediary interval) is provided between two structures, the lower side surface of one structure is adjacent to or is directly connected to the upper side surface of the intermediate structure, and the upper side surface of the other structure is adjacent to or is directly connected to the lower side surface of the intermediate structure. The intermediary structure may be formed by a single-layer or multi-layer physical structure or a non-physical structure, which is not particularly limited. In the disclosure, when a specific structure is arranged to be "on" another structure, it may mean that the specific structure is "directly" on another structure, or it may mean that the specific structure is "indirectly" on another structure, that is, at least one structure is provided between the specific structure and the another structure.

The terms "about", "substantially", or "approximately" are generally interpreted as being within 10% of a given value or range, or within 5%, 3%, 2%, 1%, or 0.5% of a given value or range. In addition, the wordings "the range is from the first numerical value to the second numerical value" and "the range falls between the first numerical value and the second numerical value" mean that the range includes the first numerical value, the second numerical value, and other numerical values therebetween.

Terms such as "first" and "second" used in the specification and the claims are used to modify elements, and the terminologies do not imply and represent that the element(s) have any previous ordinal numbers, nor do they represent the order of a specific element and another element or the order of a manufacturing method. The use of the ordinal numbers is only used to clearly distinguish between an element with a specific name and another element with the same name. The claims and the specification may not use the same terminologies. Accordingly, in the specification, a first member may be a second member in the claims.

An electrical connection or coupling relationship described in this disclosure may refer to a direct connection or an indirect connection. In the case of the direct connection, end points of the elements on two circuits are directly connected or connected to each other by a conductor segment, and in the case of the indirect connection, there are switches, diodes, capacitors, inductors, resistors, other appropriate elements, or a combination of the above elements between the end points of the elements on the two circuits, which should not be construed as a limitation in the disclosure.

In the disclosure, the thickness, length, and width may be measured by an optical microscope (OM), and the thickness may be measured from a cross-sectional image in an electron microscope, but the disclosure is not limited thereto. In addition, certain errors between any two values or directions for comparison may be acceptable. In addition, the wordings "the given range is from the first numerical value to the second numerical value", "the given range falls within the range of the first numerical value to the second numerical value", or "the given range falls between the first numerical value and the second numerical value" mean that the given range includes the first numerical value, the second numerical value, and other numerical values therebetween. If the first direction is perpendicular to the second direction, the angle between the first direction and the second direction may be between 80 degrees and 100 degrees. If the first direction is parallel to the second direction, the angle between the first direction and the second direction may be between 0 degrees and 10 degrees.

Unless otherwise defined, all terms (including technical and scientific terms) used herein have the same meaning as commonly understood by a person having ordinary skill in the art. It is understood that these terms, such as those defined in commonly used dictionaries, should be interpreted as having a meaning consistent with the background or context of the relevant technology and the disclosure, and should not be interpreted in an idealized or excessively formal manner unless specifically defined in the embodiments of the disclosure.

In the disclosure, the electronic device may include but not limited to a display device, a backlight device, an antenna device, a packaging device, a sensing device, or a splicing device. The electronic device may be a bendable or flexible electronic device. The display device may be a non-self-luminous display device or a self-luminous display device. The display device may include but not limited to liquid crystal, a light emitting diode, fluorescence, phosphor, or quantum dots (QDs), other suitable display media, or a combination of the foregoing. The antenna device may include, for example, a reconfigurable intelligent surface (RIS), a frequency selective surface (FSS), a radio frequency filter (RF-filter), a polarizer, a resonator, or an antenna. The antenna may be a liquid crystal type antenna or a varactor diode antenna. The sensing device may be a sensing device that senses capacitance, light, heat energy, or ultrasound, but the disclosure is not limited thereto. In the disclosure, the electronic device may include an electronic element, and the electronic element may include a passive element and an active element, such as a capacitor, a resistor, an inductor, a diode, a transistor, etc. The diodes may include light-emitting diodes (LEDs), varactor diodes, or photodiodes. The LEDs may include but not limited to organic LEDs (OLEDs), sub-millimeter LEDs (mini LEDs), micro LEDs, or quantum dot LEDs. The splicing device may be, for example, a display splicing device or an antenna splicing device, but the disclosure is not limited thereto. Note that the electronic device may be any combination of the foregoing, but the disclosure is not limited thereto. The packaging device may be a packaging device applicable to a wafer-level package (WLP) technology or a panel-level package (WLP) technology, such as a chip first process or a chip last (RDL first) process. Besides, the appearance of the electronic device may be rectangular, circular, polygonal, or a shape with curved edges, or other suitable shapes. The electronic device may have a peripheral system such as a drive system, a control system, a light source system, etc. to support a display device, an antenna device, a wearable device (such as including augmented reality or virtual reality), a vehicle-mounted device (such as including a car windshield), or a splicing device.

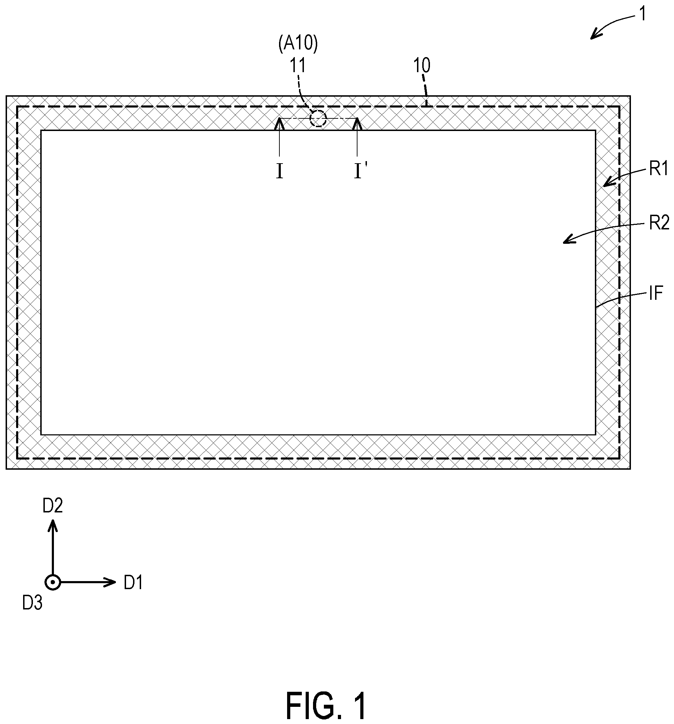

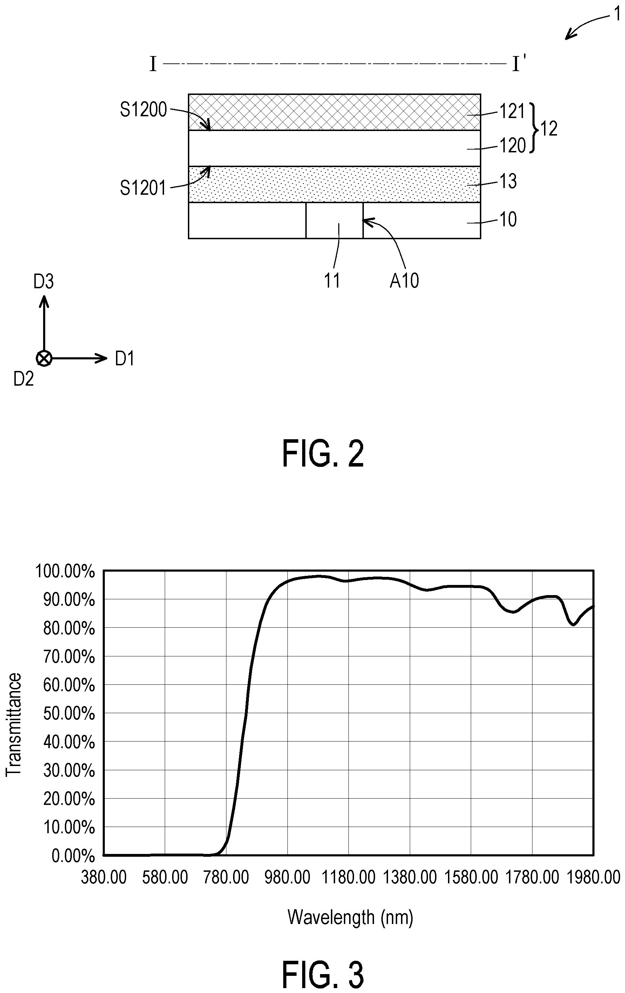

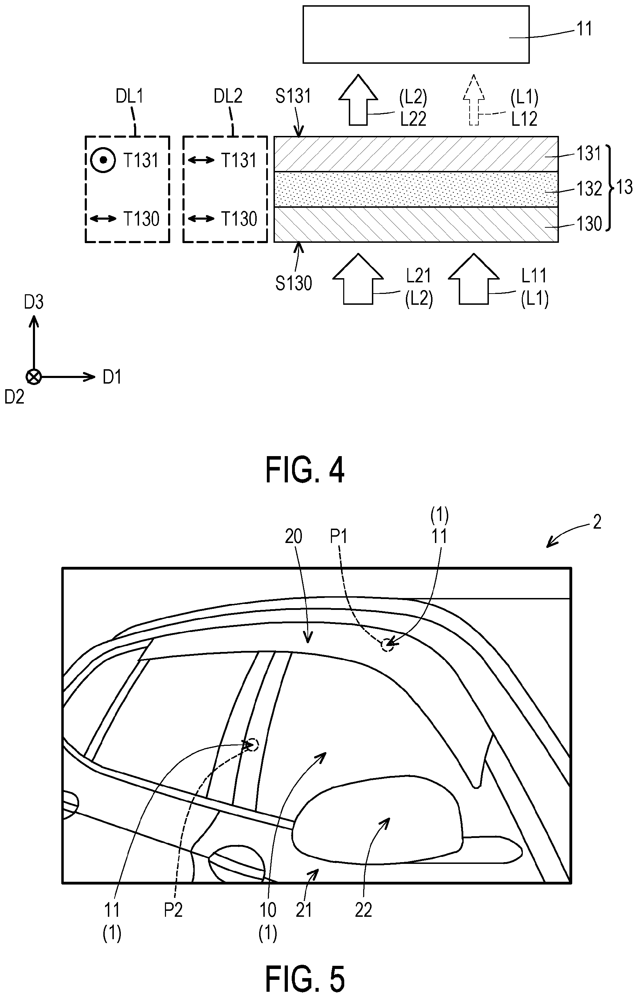

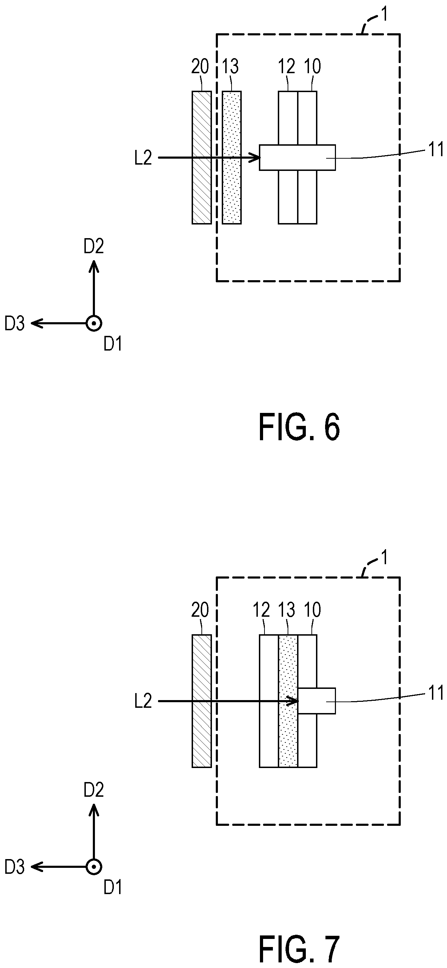

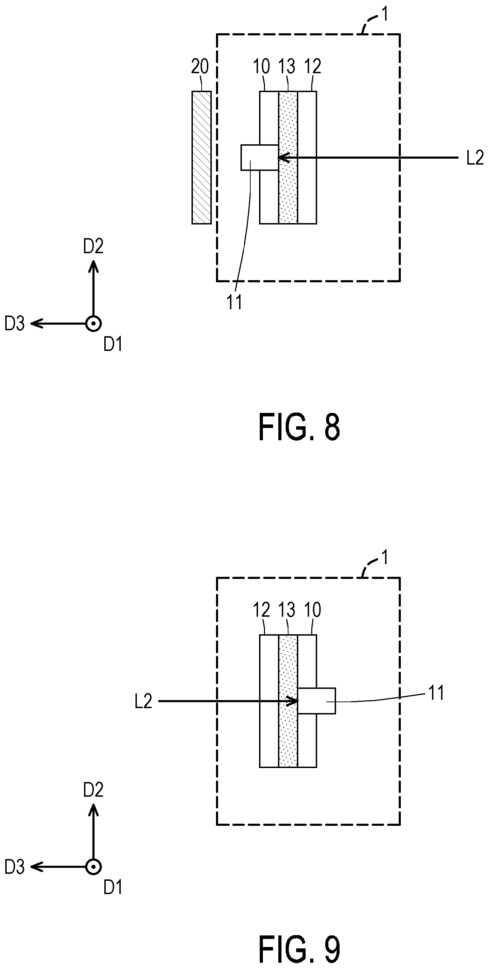

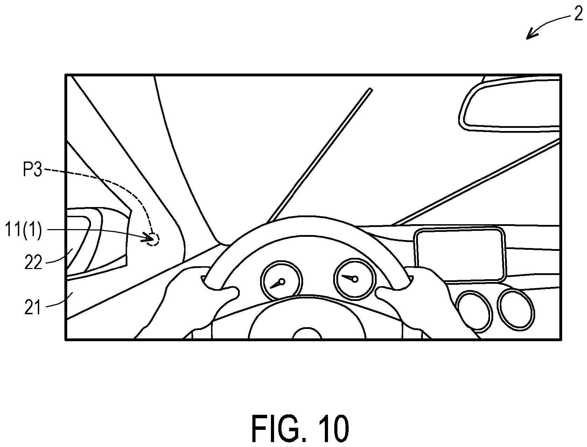

FIG. 1 is a schematic top view of a display device according to some embodiments of the disclosure. FIG. 2 is a schematic cross-sectional view corresponding to a sectional line I-I' in FIG. 1. FIG. 3 is a graph of a wavelength-transmittance relationship of an optical component in FIG. 2. FIG. 4 is a partially enlarged schematic view of the optical component and an optical sensing unit in FIG. 2. FIG. 5 is a partial schematic view of an exterior of a transportation device. FIG. 6 and FIG. 9 are partial cross-sectional schematic views of various display devices according to some embodiments of the disclosure. FIG. 10 is a partial schematic view of an interior of a transportation device. It should be understood that the following embodiments may replace, reorganize, and mix the features in several different embodiments to complete other embodiments without departing from the spirit of the disclosure. As long as the features of the embodiments do not violate the spirit of the disclosure or conflict each other, they may be mixed and matched as desired.

With reference to FIG. 1 to FIG. 4, a display device 1 may include a display panel 10, an optical sensing unit 11, a protective component 12, and an optical component 13. The optical sensing unit 11 is embedded in the display panel 10 and is located in a peripheral region R1 of the display device 1. The protective component 12 disposed on the display panel 10. The optical component 13 is adjacent to a light entrance side S11 of the optical sensing unit 11. A transmittance of the optical component 13 to light L1 with a wavelength greater than or equal to 380 nm and less than or equal to 780 nm is less than 10%, and a transmittance of the optical component 13 to light L2 with a wavelength greater than or equal to 900 nm and less than or equal to 1100 nm is higher than 70%.

In detail, as shown in FIG. 1, in addition to the peripheral region R1, the display device 1 may also have a display region R2. The display region R2 may be used to display an image, and the peripheral region R1 may be used to accommodate components in the display device 1 that are not to be seen by a user, such as the optical sensing unit 11, a peripheral circuit (not shown), a driving component (not shown), or other components (not shown). Optionally, the peripheral region R1 may also be provided with at least one component or film layer (e.g., a decorative film) for hiding the above-mentioned components or lowering visibility of the above-mentioned components. It should be noted that a first component "embedded" in a second component may be defined as the first component being located in the second component in a top view direction, and the first component may or may not penetrate the second component in a cross-sectional direction. In other embodiments, the first component "embedded" in the second component may be defined as the first component being located under the second component. For instance, the second component has an opening, and the first component is disposed under the opening of the second component and at least partially overlaps with the opening of the second component, but the disclosure is not limited thereto.

The peripheral region R1 may be located at at least one side of the display region R2, and the peripheral region R1 and the display region R2 may be connected to each other. For instance, as shown in FIG. 1, the peripheral region R1 may be a region outside the display region R2, and the peripheral region R1 may be located around the display region R2, such that the peripheral region R1 and the display region R2 have a rectangular interface IF. In detail, in FIG. 1, two long sides of the interface IF extend in a direction D1, and two short sides of the interface IF extend in a direction D2, where the directions D1 and D2 intersect each other and are both perpendicular to a thickness direction (e.g., direction D3) of the display device 1. In some embodiments, as shown in FIG. 1, the direction D1 and the direction D2 may be perpendicular to each other, but the disclosure is not limited thereto. In other embodiments that are not shown, the direction D1 may not be parallel to or perpendicular to the direction D2. For instance, an angle between the direction D1 and the direction D2 may be a non-right angle, such as a sharp angle or a blunt angle.

In the display device 1, the display panel 10 may be used to provide an image, and the display panel 10 is at least located in the display region R2, so that a user can see the image from the display region R2 of the display device 1. In some embodiments, as shown in FIG. 1, an edge portion of the display panel 10 may be located in the peripheral region R1, that is, the display panel 10 partially overlaps the peripheral region R1 in the direction D3, so that an edge (indicated by a dotted line in FIG. 1) of the display panel 10 is blurred, but the disclosure is not limited thereto.

A type of the display panel 10 is not limited. For instance, the display panel 10 may include a self-luminous display panel or a non-self-luminous display panel. The self-luminous display panel may include a light-emitting diode display panel, an organic light-emitting diode display panel, a sub-millimeter light-emitting diode display panel, a micro light-emitting diode display panel, or a quantum dot light-emitting diode display panel, but the disclosure is not limited thereto. The non-self-luminous display panel may include a liquid crystal display panel, but the dis closure is not limited thereto. In the embodiment where the display panel 10 is a non-self-luminous display panel, the display device 1 may further include a backlight module (not shown) to provide illumination light. The display panel 10 is located on a transmission path of the illumination light to convert the illumination light into image light with image information (e.g., grayscale, color).

In the display device 1, the optical sensing unit 11 is embedded in the display panel 10 and is located in the peripheral region R1 (with reference to FIG. 1) of the display device 1. For instance, the display panel 10 in the peripheral region R1 may be formed with an opening A10 for accommodating the optical sensing unit 11. Further, the optical sensing unit 11 may be fixed in the opening A10 through an adhesive layer (not shown), an engaging structure (not shown), or other components (not shown, e.g., a sleeve, foam, or rubber, etc.).

The optical sensing unit 11 may include one or a plurality of light sensors (not shown) to sense an external image. Optionally, the optical sensing unit 11 may further include one or a plurality of light emitters (not shown) to provide sensing light for sensing an image. Optionally, the optical sensing unit 11 may further include one or a plurality of optical components (not shown, e.g., a lens component, an aperture, and/or other types of optical components) disposed in front of the light sensor and/or the light emitter, so as to change a transmission direction and/or divergence angle of the sensing light and accordingly reduce loss of the sensing light during the transmission process.

In some embodiments, a light emission spectrum of the light emitter may be matched with an absorption response spectrum of the light sensor to improve light conversion efficiency of the light sensor. In some embodiments, the light sensor and the light emitter are respectively a non-visible light sensor and a non-visible light emitter, that is, the sensing light (non-visible light) used for image sensing is different from the image light (visible light) used for display. In some embodiments, non-visible light may include near-infrared light or infrared light, such as light having a wavelength of 850 nm or 940 nm, but the disclosure is not limited thereto. In an embodiment where the sensing light and the image light are in different wavelength bands, the visible light transmitted to the light sensor may be filtered by a filter to reduce the interference of the visible light on the image sensing. The filter may be an additional filter component disposed between the light sensor and the optical component 13 in the optical sensing unit 11. Alternatively, the optical component 13 may act as a filter to filter the visible light incident on the light sensor (to be described in the following paragraphs), so an additional filter component may not have to be arranged.

In the display device 1, the protective component 12 may be used to protect the components or film layers thereunder and provide visual and/or tactile effects. For instance, the protective component 12 may include a cover plate 120, a decorative film 121, or a combination of the foregoing. The cover plate 120 may be used to protect the components or film layers thereunder. The cover plate 120 may be a rigid substrate or a flexible substrate. A material of the cover plate includes but not limited to, for example, glass, quartz, ceramic, sapphire, or plastic. The plastic may include but not limited to polycarbonate (PC), polyimide (PI), polypropylene (PP), polyethylene terephthalate (PET), other suitable flexible materials or a combination of the foregoing materials.

The decorative film 121 may be used to provide visual and/or tactile effects. The visual effects may include color, pattern, transparency, text, and/or other visual sensations. The tactile effects may include tactile sensations such as bumps and roughness. In some embodiments, as shown in FIG. 2, the decorative film 121 may be disposed on an outer surface S1200 (e.g., a surface of the cover plate 120 facing the user) of the cover plate 120. For instance, the decorative film 121 may be formed on the outer surface S1200 of the cover plate 120 by printing or laminating to provide a visual effect and/or tactile effect of a decorative pattern (e.g., leather pattern, wood pattern, metal pattern, leopard pattern, or other patterns).

Alternatively, although not shown in FIG. 2, the decorative film 121 may be formed on an inner surface S1201 of the cover plate 120 by printing or laminating to provide a visual effect of a decorative pattern. Optionally, in the embodiment where the decorative film 121 is disposed on the inner surface S1201 of the cover plate 120, a tactile effect corresponding to the decorative pattern may be provided by embossing, etching, or other surface treatment methods on the outer surface S1200 of the cover plate 120, but the disclosure is not limited thereto.

In the display device 1, the optical component 13 may be disposed between the protective component 12 and the optical sensing unit 11. To be specific, the optical component 13 may be used to filter the visible light incident on the optical sensing unit 11 (including the light sensor), so as to reduce the visibility of the optical sensing unit 11 and/or reduce the interference of the visible light on image sensing. Therefore, the optical component 13 at least overlaps the optical sensing unit 11 in the direction D3. In some embodiments, the optical component 13 may cover the optical sensing unit 11. In some embodiments, as shown in FIG. 2, the optical component 13 may cover the optical sensing unit 11 and the display panel 10.

FIG. 3 illustrates transmittances of the optical component 13 to light of various wavelengths. As shown in FIG. 3, the transmittance of the optical component 13 to light with a wavelength greater than or equal to 380 nm and less than or equal to 780 nm is less than 10% (e.g., close to 0%), and the transmittance of the optical component 13 to light with a wavelength greater than or equal to 900 nm and less than or equal to 1100 nm is higher than 70%. The wavelength of light with a transmittance higher than 70% may be, for example, 920 nm, 940 nm, 960 nm, 980 nm, 1000 nm, 1020 nm, and 1040 nm, but the disclosure is not limited thereto. In addition, the transmittance of the optical component 13 to light with a wavelength greater than or equal to 780 nm and less than or equal to 900 nm increases as the wavelength increases, for example.

As shown in FIG. 3, the transmittance of the optical component 13 to light with a wavelength greater than or equal to 610 nm and less than or equal to 780 nm is less than 10% (e.g., close to 0%), and the transmittance of the optical component 13 to light with a wavelength greater than or equal to 380 nm and less than or equal to 430 nm is less than 10% (e.g., close to 0%) as well. By utilizing the low transmittance characteristic of the optical component 13 to red light and blue light in visible light, the interference of red light and blue light in visible light on image sensing may be reduced. In addition, since the visible light (light having a wavelength greater than or equal to 380 nm and less than or equal to 780 nm) transmitted toward the optical sensing unit 11 is effectively reduced by the optical component 13, the visible light transmitted to the optical sensing unit 11 and reflected back to the human eye by the optical sensing unit 11 is also greatly reduced. Therefore, the optical component 13 may reduce the visibility of the optical sensing unit 11.

With reference to FIG. 4, "the transmittance of the optical component 13 to light of a specific wavelength band" refers to light intensity of the light in the wavelength band after entering a light incident surface S130 of the optical component 13 and emitting from a light-emitting surface S131 of the optical component 13 divided by the light intensity of the light in the wavelength band when it enters the light incident surface S130 of the optical component 13. In FIG. 4, L1 represents light (e.g., visible light) having a wavelength greater than or equal to 380 nm and less than or equal to 780 nm, where L11 represents the light intensity when the light L1 enters the light incident surface S130 of the optical component 13, and L12 represents the light intensity when the light L1 is emitted from the light-emitting surface S131 of the optical component 13. The transmittance of the optical component 13 to the light L1 is equal to the light intensity L12 divided by the light intensity L11, that is, L12/L11. As shown in FIG. 3, the transmittance of the optical component 13 to the light L1 (with a wavelength greater than or equal to 380 nm and less than or equal to 780 nm) is less than 10% and close to 0%. That is, most (more than 90%) of the light L1 incident on the optical component 13 is blocked by the optical component 13.

In FIG. 4, L2 represents light (e.g., non-visible light such as near-infrared light or infrared light) having a wavelength greater than or equal to 900 nm and less than or equal to 1100 nm, where L21 represents the light intensity when the light L2 enters the light incident surface S130 of the optical component 13, and L22 represents the light intensity when the light L2 is emitted from the light-emitting surface S131 of the optical component 13. The transmittance of the optical component 13 to the light L2 is equal to the light intensity L22 divided by the light intensity L21, that is, L22/L21. As shown in FIG. 3, the transmittance of the optical component 13 to the light L2 (with a wavelength greater than or equal to 900 nm and less than or equal to 1100 nm) is higher than 70%. That is, most (more than 70%) of the light L2 incident on the optical component 13 penetrates the optical component 13 and is transmitted to the optical sensing unit 11.

By utilizing the low transmittance characteristic of the optical component 13 to visible light (for example, light L1 having a wavelength greater than or equal to 380 nm and less than or equal to 780 nm) and arranging the optical component 13 on the transmission path of the visible light transmitted toward the optical sensing unit 11, the interference to image sensing caused by the optical sensing unit 11 receiving visible light may be reduced, and the visible light that penetrates the optical component 13 and then is reflected back to the human eye by the optical sensing unit 11 may also be reduced. Therefore, the visibility of the optical sensing unit 11 may be reduced. On the other hand, by utilizing the high transmittance characteristic of the optical component 13 to non-visible light (for example, light L2 with a wavelength greater than or equal to 900 nm and less than or equal to 1100 nm), the shielding of the optical component 13 for non-visible light may be reduced. In this way, most of the non-visible light from the light emitter may penetrate the optical component 13 and be transmitted to an object to be measured. Further, most of the non-visible light reflected by the object to be measured may penetrate the optical component 13 and be transmitted to the optical sensing unit 11, so that image sensing may be carried out smoothly.

In some embodiments, as shown in FIG. 4, the optical component 13 may include a first polarizer 130 having a first transmission axis T130 and a second polarizer 131 having a second transmission axis T131. The first transmission axis T130 may be parallel to or perpendicular to the second transmission axis T131. A material of the first polarizer 130 and the second polarizer 131 includes but not limited to polyvinyl alcohol (PVA), for example.

In some embodiments, as shown by a dashed frame DL1 in FIG. 4, the first transmission axis T130 may be perpendicular to the second transmission axis T131. In the dashed frame DL1, the first transmission axis T130 and the second transmission axis T131 are parallel to the direction D1 and the direction D2, respectively, but the disclosure is not limited thereto. In other embodiments that are not shown, the first transmission axis T130 may be parallel to any direction perpendicular to the direction D3, and the second transmission axis T131 may be parallel to any direction perpendicular to both the direction D3 and the first transmission axis T130. Alternatively, an angle between the first transmission axis T130 and the second transmission axis T131 may be greater than or equal to 70 degrees and less than or equal to 90 degrees. In the embodiment where the first transmission axis T130 and the second transmission axis T131 are perpendicular or nearly perpendicular to each other, most of the visible light (as described above or shown in FIG. 3) transmitted toward the optical sensing unit 11 may be filtered by the first polarizer 130 and the second polarizer 131 whose transmission axes are perpendicular or nearly perpendicular to each other.

Optionally, the optical component 13 may further include an intermediate component 132 disposed between the first polarizer 130 and the second polarizer 131. For instance, the intermediate component 132 may include an adhesive layer for bonding the first polarizer 130 and the second polarizer 131. The adhesive layer may include but not limited to optical clear adhesive (OCA) or optical clear resin (OCR). In some embodiments, the adhesive layer may further include a material (e.g., carbon black or light-absorbing particles, etc.) that can change the transmittance, so that the peripheral region R1 and the display region R2 of the display device 1 display nearly the same black color (integral black) when the device is turned off, in a standby mode, or displaying a black screen.

In some embodiments, the intermediate component 132 may include at least one phase delay plate, such as at least one half-wave plate, at least one quarter-wave plate, other phase delay components, or a combination of the foregoing. For instance, the intermediate component 131 may include 2N half-wave plates and 4N quarter-wave plates or may provide other combinations of deflection angles that are integer multiples of 180 degrees to the incident light (that is, a polarization direction of the light incident on the intermediate component 132 is parallel to a polarization direction of the light emitted from the intermediate component 132), where N is a positive integer greater than or equal to 1. For instance, the intermediate component 132 may include two half-wave plates or four quarter-wave plates to provide a 180-degree deflection angle to the incident light. For instance, the intermediate component 132 may include one half-wave plate and two quarter-wave plates to provide a 180-degree deflection angle to the incident light. For instance, the intermediate component 132 may include two half-wave plates and four quarter-wave plates to provide a 360-degree deflection angle to the incident light. Although not shown, a plurality of wave plates may be fixed together by an adhesive layer or other mechanisms.

In some embodiments, as shown by a dashed frame DL2 in FIG. 4, the first transmission axis T130 may be parallel to the second transmission axis T131. In the dashed frame DL2, the first transmission axis T130 and the second transmission axis T131 are both parallel to the direction D1, but the disclosure is not limited thereto. In other embodiments that are not shown, the first transmission axis T130 and the second transmission axis T131 may be parallel to any direction perpendicular to the direction D3.

In the embodiment where the first transmission axis T130 and the second transmission axis T131 are parallel to each other, the optical component 13 may also include the intermediate component 132 disposed between the first polarizer 130 and the second polarizer 131. As described in the foregoing paragraphs, the intermediate component 132 may include an adhesive layer for bonding the first polarizer 130 and the second polarizer 131. In some embodiments, the adhesive layer may further include a material (e.g., carbon black or light-absorbing particles, etc.) that can change the transmittance, so that the peripheral region R1 and the display region R2 of the display device 1 display nearly the same black color (integral black) when the device is turned off, in the standby mode, or displaying a black screen.

In some embodiments, the intermediate component 132 may include at least one phase delay plate, such as at least one half-wave plate, at least one quarter-wave plate, other phase delay components, or a combination of the foregoing. For instance, the intermediate component 131 may include (2N-1) half-wave plates and (4N-2) quarter-wave plates or may provide other combinations of deflection angles that are odd integer multiples of 90 degrees to the incident light (that is, the polarization direction of the light incident on the intermediate component 132 is perpendicular to the polarization direction of the light emitted from the intermediate component 132), where N is a positive integer greater than or equal to 1. For instance, the intermediate component 132 may include one half-wave plate or two quarter-wave plates to provide a 90-degree deflection angle to the incident light. For instance, the intermediate component 132 may include two half-wave plates and two quarter-wave plates to provide a 270-degree deflection angle to the incident light. Although not shown, a plurality of wave plates may be fixed together by an adhesive layer or other mechanisms.

The light (e.g., light L1) incident on the first polarizer 130 is, for example, non-polarized light, and the light L1 becomes first linearly polarized light (not shown) after passing through the first polarizer 130. Further, a polarization direction (not shown) of the first linearly polarized light is parallel to the first transmission axis T130 of the first polarizer 130. The first linearly polarized light is transformed into a second linearly polarized light (not shown) after passing through a phase delay plate (e.g., the intermediate component 132). Further, a polarization direction (not shown) of the second linearly polarized light is perpendicular to the first transmission axis T130 of the first polarizer 130 and the second transmission axis T131 of the second polarizer 131. Therefore, the second linearly polarized light is filtered by the second polarizer 131. In other words, by using the first polarizer 130 and the second polarizer 131 with parallel transmission axes in combination with the phase delay plate (e.g., intermediate component 132), most of the visible light (as described above or shown in FIG. 3) transmitted toward the optical sensing unit 11 may be filtered.

In some embodiments, although not shown in FIG. 4, the optical component 13 may further include at least one protective layer. The at least one protective layer may be disposed on a surface of the first polarizer 130 away from the intermediate component 132, between the first polarizer 130 and the intermediate component 132, between the intermediate component 132 and the second polarizer 131, on a surface of the second polarizer 131 away from the intermediate component 132, or a combination of the foregoing. A material of the protective layer may include triacetate cellulose (TAC), polyethylene terephthalate (PET), polymethyl methacrylate (PMMA), or a combination of the foregoing. In some embodiments, although not shown in FIG. 4, the optical component 13 may further include an anti-scratch layer (e.g., a hard coating layer), a low reflection layer, an anti-reflection layer, an anti-smudge layer, an anti-fingerprint layer, or an optical layer with other functions disposed on the surface of the first polarizer 130 away from the intermediate component 132.

In some embodiments, although not shown, the intermediate component 132 of FIG. 4 may be replaced by a polyvinyl alcohol (PVA) layer, and the first polarizer 130 and the second polarizer 131 of FIG. 4 may be replaced by a first protective layer and a second protective layer, respectively. The polyvinyl alcohol layer is not stretched so as to have the effect of two orthogonal polarizers, and iodine ions may be added to the polyvinyl alcohol layer to enhance the effect of the optical component 13 in allowing infrared light to pass through and filtering visible light. Materials of the first protective layer and the second protective layer include triacetate cellulose (TAC), polyethylene terephthalate (PET), polymethyl methacrylate (PMMA), or a combination of the foregoing.

With reference to FIG. 5, in some embodiments, the display device 1 may be applied in a vehicle 2. A type of vehicle 2 is not limited. In terms of power, the vehicle may be a petrol vehicle (such as a gasoline vehicle or a diesel vehicle), a hybrid vehicle, or an electric vehicle, but the disclosure is not limited thereto. In terms of appearance or function, the vehicle may be a sedan, a SUV, a sports car, a truck, a bus, a military vehicle, a racing car, a special vehicle, an engineering vehicle, or a camper, but the disclosure is not limited thereto.

In some embodiments, the display panel 10 of the display device 1 may be a transparent display panel, and the display panel 10 may act as a vehicle window, for example, but the disclosure is not limited thereto. In some embodiments, the optical sensing unit 11 of the display device 1 may be hidden under a rain shield strip 20 of the vehicle 2, such as at a position P1 marked in FIG. 5, but the disclosure is not limited thereto. In some other embodiments, the optical sensing unit 11 of the display device 1 may be disposed on a side of a vehicle door 21, for example, on a side of an upper half of the vehicle door 21 far from a rear-view mirror 22, such as at a position P2 marked in FIG. 5, but the disclosure is not limited thereto.

FIG. 6 illustrates an embodiment in which the optical sensing unit 11 is disposed at the position P1 (with reference to FIG. 5). With reference to FIG. 6, the protective component 12 may be disposed between the optical component 13 and the display panel 10, and the optical sensing unit 11 may also be embedded in the protective component 12. In addition, the optical component 13 is, for example, disposed between the rain shield strip 20 and the optical sensing unit 11. In this structure, the optical sensing unit 11 may be used to detect an image outside the vehicle 2, such as detecting the light L2 reflected by the object to be measured. For instance, the optical sensing unit 11 may be used to identify an owner of the vehicle to provide an automatic unlocking function for the vehicle, but the disclosure is not limited thereto.

FIG. 7 illustrates another embodiment in which the optical sensing unit 11 is disposed at the position P1 (with reference to FIG. 5). With reference to FIG. 7, the optical component 13 may be disposed between the protective component 12 and the display panel 10. In this structure, the optical sensing unit 11 may also be used to detect an image outside the vehicle 2.

FIG. 8 illustrates still another embodiment in which the optical sensing unit 11 is disposed at the position P1 (with reference to FIG. 5). With reference to FIG. 8, the main difference between this embodiment and FIG. 7 is that the positions of the protective component 12 and the display panel 10 are interchanged, and the optical sensing unit 11 is used to detect an image inside the vehicle 2. For instance, the optical sensing unit 11 may be used for driver monitoring or passenger monitoring, but the disclosure is not limited thereto.

FIG. 9 illustrates an embodiment in which the optical sensing unit 11 is disposed at the position P2 (with reference to FIG. 5). With reference to FIG. 9, the main difference between this embodiment and FIG. 7 is that there is no rain shield strip 20 in front of the protective component 12. In some embodiments, the display device 1 shown in FIG. 9 may also be disposed at a corner of the vehicle door 21 adjacent to the rear-view mirror 22, such as at a position P3 marked in FIG. 10, but the disclosure is not limited thereto.

In view of the foregoing, in the embodiments of the disclosure, by utilizing the low transmittance characteristic of the optical component to visible light (for example, light having a wavelength greater than or equal to 380 nm and less than or equal to 780 nm) and arranging the optical component on the transmission path of the visible light transmitted toward the optical sensing unit, the interference to image sensing caused by the optical sensing unit receiving visible light may be reduced, and the visible light that penetrates the optical component and then is reflected back to the human eye by the optical sensing unit may also be reduced. Therefore, the visibility of the optical sensing unit may be reduced. Further, by utilizing the high transmittance characteristic of the optical component to non-visible light (for example, light with a wavelength greater than or equal to 900 nm and less than or equal to 1100 nm), the shielding of the optical component for non-visible light may be reduced, so image sensing may be carried out smoothly.

The foregoing embodiments are merely described to illustrate the technical means of the disclosure and should not be construed as limitations of the disclosure. Even though the foregoing embodiments are referenced to provide detailed description of the disclosure, a person having ordinary skill in the art should understand that various modifications and variations can be made to the technical means in the disclosed embodiments, or equivalent replacements may be made for part or all of the technical features. Nevertheless, it is intended that the modifications, variations, and replacements shall not make the nature of the technical means to depart from the scope of the technical means of the embodiments of the disclosure.

Although the embodiments of the disclosure and advantages thereof are disclosed as above, it should be understood that a person having ordinary skill in the art may make changes, substitutions, and modifications without departing from the spirit and scope of the disclosure. Further, the features between the embodiments may be randomly mixed and replaced to form other new embodiments. Moreover, the scope of the disclosure is not intended to be limited to the particular embodiments of the processes, machines, manufactures, compositions of matters, means, methods, and steps described in the specification. As a person having ordinary skill in the art will readily appreciate from the disclosure, the processes, machines, manufacture, compositions of matters, means, methods, or steps, presently existing or later to be developed, that perform substantially the same function or achieve substantially the same result as the corresponding embodiments described herein may be utilized according to the disclosure. Accordingly, the claims of the disclosure are intended to include within their scope of such processes, machines, manufacture, compositions of matter, means, methods, and/or steps. Further, each claim constitutes an individual embodiment, and the scope of the disclosure further covers a combination of each claim and the respective embodiment. The protection scope of the disclosure shall be defined by the appended claims.

## Claims

1. A display device (1), comprising:
a display panel (10);
an optical sensing unit (11) embedded in the display panel (10) and located in a peripheral region (R1) of the display device (1); and
an optical component (13) adjacent to a light entrance side (S11) of the optical sensing unit (11), wherein a transmittance of the optical component (13) to light (L1) with a wavelength greater than or equal to 380 nm and less than or equal to 780 nm is less than 10%, and a transmittance of the optical component (13) to light (L2) with a wavelength greater than or equal to 900 nm and less than or equal to 1100 nm is higher than 70%.

2. The display device (1) according to claim 1, wherein a transmittance of the optical component (13) to light with a wavelength greater than or equal to 610 nm and less than or equal to 780 nm is less than 10%.

3. The display device (1) according to claim 1 or claim 2, wherein a transmittance of the optical component (13) to light with a wavelength greater than or equal to 380 nm and less than or equal to 430 nm is less than 10%.

4. The display device (1) according to any one of claims 1 to 3, wherein the display panel (10) is a transparent display panel.

5. The display device (1) according to any one of claims 1 to 4, further comprising a protective component (12) disposed on the display panel (10).

6. The display device (1) according to claim 5, wherein the protective component (12) comprises a cover plate (120), a decorative film (121), or a combination of the foregoing.

7. The display device (1) according to claim 5, wherein the optical component (13) is disposed between the protective component (12) and the optical sensing unit (11).

8. The display device (1) according to claim 5, wherein the protective component (12) is disposed between the optical component (13) and the display panel (10), and the optical sensing unit (11) is also embedded in the protective component (12).

9. The display device (1) according to claim 5, wherein the optical component (13) is disposed between the protective component (12) and the display panel (10).

10. The display device (1) according to any one of claims 1 to 9, wherein the optical component (13) comprises a first polarizer (130) having a first transmission axis (T130) and a second polarizer (131) having a second transmission axis (T131), and the first transmission axis (T130) is parallel to or perpendicular to the second transmission axis (T131).

11. The display device (1) according to claim 10, wherein the optical component (13) further comprises at least one half-wave plate, at least one quarter-wave plate, or a combination of the foregoing disposed between the first polarizer (130) and the second polarizer (131).

12. The display device (1) according to claim 10, wherein the optical component (13) further comprises an adhesive layer disposed between the first polarizer (130) and the second polarizer (131).

13. The display device (1) according to claim 12, wherein the adhesive layer comprises carbon black or light-absorbing particles.

14. The display device (1) according to any one of claims 1 to 13, wherein a transmittance of the optical component (13) to light with a wavelength greater than or equal to 780 nm and less than or equal to 900 nm increases as the wavelength increases.

15. The display device (1) according to any one of claims 1 to 10, wherein the optical component (13) comprises a first protective layer, a second protective layer, and a polyvinyl alcohol layer disposed between the first protective layer and the second protective layer, wherein the polyvinyl alcohol layer is not stretched, and iodine ions are added to the polyvinyl alcohol layer.
